# EUROPEAN PATENT SPECIFICATION

(11) **EP 1 906 436 B1**
(45) Date of publication and mention of the grant of the patent: **05.06.2019**
(21) Application number: 07019073.1
(22) Date of filing: 27.09.2007
(51) Int. Cl.: H01L 25/065, H01L 23/31

(54) **Semiconductor-embedded substrate and manufacturing method thereof**
Halbleiterspeichereingebettetes Substrat und Herstellungsverfahren dafür
Substrat de montage intégré et son procédé de fabrication

(30) Priority: 29.09.2006 JP 2006268446
(43) Date of publication of application: 02.04.2008
(73) Proprietor: TDK Corporation, Tokyo 108-0023 (JP)
(72) Inventor: Hattori, Yasuyuki, Tokyo 103-8272 (JP); Endo, Toshikazu, Tokyo 103-8272 (JP); Katsumata, Masashi, Tokyo 103-8272 (JP); Morita, Takaaki, Tokyo 103-8272 (JP); Kawabata, Kenichi, Tokyo 103-8272 (JP)
(74) Representative: Grünecker Patent- und Rechtsanwälte PartG mbB

(56) References cited:
- EP-A- 1 189 280
- WO-A-2006/054339
- JP-A- 58 090 744
- JP-A- 58 090 745
- JP-A- 2001 085 804
- JP-A- 2004 200 316

## Description

### BACKGROUND OF THE INVENTION

The present invention relates to a semiconductor-embedded substrate having, in an insulating layer thereof, a semiconductor device.

A substrate having a semiconductor device (IC or another device) mounted thereon typically has a structure in which the semiconductor device (die) in the form of a bare chip has been mounted on the surface of a multilayer substrate made of a plurality of resin layers. In this case, wire bonding or flip chip connection is usually employed for the connection between a land electrode of the semiconductor device to be mounted and an internal wiring pattern of the multilayer substrate.

When wire bonding is employed in such a structure, a problem of inevitable increase in a mounting area occurs because a region in which the semiconductor device has been mounted and a region for connecting one end of a bonding wire must be formed on different planes of one multilayer substrate. When flip chip connection is employed, on the other hand, a mounting area can be decreased, but a multilayer under-barrier metal must be disposed on the surface of the land electrode in order to ensure sufficient mechanical connection strength between the land electrode and wiring pattern, which poses a problem such as complicated manufacturing steps.

For example, there is an ever-increasing eager demand for high-density packaging of portable appliances typified by mobile phones. In recent years, a demand for thinning of them is particularly increasing. Even if either one of the above-described two connection methods is employed, a semiconductor device must be mounted on the surface of a multilayer substrate as usual and it is difficult to thin a mounting substrate. It was therefore impossible to fully satisfy the request for thinning portable appliances and the like further.

With a view to meeting the request for thinning, described in Japanese Patent Laid-Open No. 09-321408 is a high density mounting structure of an electron circuit substrate obtained by embedding a semiconductor device in the form of a bare chip in a multilayer substrate. Since the semiconductor device generates heat during its operation, it needs a measure for dissipating heat to the exterior and ensuring the reliability of the device. It is however difficult to attach a heat radiation member such as heat sink or radiation fin directly to the semiconductor device which has been embedded inside of the substrate. Even if such a member is attached, it thickens the substrate against the demand for thinner substrates. In Japanese Patent Laid-Open No. 2006-49762, there is proposed a part-embedded substrate having semiconductor parts disposed on the surface layer of the substrate in order to realize downsizing and thinning while ensuring radiation properties of heat generated in the semiconductor device and at the same time, having a solid radiator plate made of a metal and attached to the semiconductor part with an adhesive (particularly, refer to FIG. 5 of this document). A semiconductor device having the features of the preamble of claim 1 is known from each of JP 2001 085804 A and JP 2004 200316 A.

### SUMMARY OF THE INVENTION

In the structure of the part-embedded substrate (which will hereinafter be called "conventional substrate", simply) described in Japanese Patent Laid-Open 2006-49762, however, reflow or annealing is performed to release a gas from a metal wiring layer or metal plug (a via filled with a metal) during the fabrication of a multilayer wiring structure on the semiconductor part. When a metal radiator plate is exposed to high temperature at the time of reflow or annealing, deformation (strain) or peeling of the metal radiator plate may presumably occur owing to a thermal stress attributable to a difference in linear expansion coefficient between the metal radiator plate and adhesive layer or insulating layer. This deteriorates adhesion between the metal radiator plate and adhesive and moreover adhesion between the metal radiator plate and semiconductor part and as a result, the resulting part-embedded substrate cannot realize sufficient heat radiation properties. In the conventional substrate, therefore, there is a fear of deterioration in a production yield and reliability.

When a semiconductor device to be embedded in a substrate is an IC having an extremely high operating frequency such as CPU (Central Processing Unit) or DSP (Digital Signal Processor), a great amount of heat is generated by the switching of the device. When the heat radiator plate exists immediately above the semiconductor part or neighborhood thereof, transfer of such a great amount of heat to the heat radiator plate is presumed to disturb smooth and sufficient heat radiation (the transferred amount of heat exceeds the released amount of heat). Heat accumulates in the heat radiator plate or neighborhood thereof. Owing to a thermal stress attributable to a difference in a linear expansion coefficient between the metal radiator plate and adhesive layer or insulating layer, deformation (strain, expansion) or peeling of the metal radiator plate may presumably occur during operation, which may deteriorate heat radiation properties further.

Recently, there is an increasing demand for the improvement of the processing speed of the above-described portable appliances year by year. Increase in frequency and clock rate of semiconductor devices is therefore enhanced so that heat generated by them tends to increase further. Accordingly, the above-described problem of a metal radiator plate of the conventional substrate becomes more serious.

The semiconductor-embedded substrate according to the present invention has the features of claim 1 in order to overcome the above-described problems. It is to be noted that the opening is usually filled with a material constituting the insulating layer.

The term "heat transfer coefficient" as used herein is a thermal physical property specified in Japanese Industrial Standards JIS Z 9211 and the like and it is, for example, a value obtained by dividing a heat reflux between the solid surface and surrounding fluid by a temperature difference therebetween [Z 9211] (Glossary of Technical Terms in Japanese Industrial Association, 3-rd Edition, p1375, right column, line 2-3). The term "thermal conductivity" is a thermal physical property specified in standards such as Japanese Industrial Standards JIS H 7005, K 6900, X 8106 and Z 9211 and any standard may be used as the definition. For example, the term "thermal conductivity" means a ratio of a heat amount flowing vertically in a unit time through a unit area of an isothermal surface inside of an object to a temperature gradient in this direction [Z 8106] (ditto, p 1376, left column, from lines 15 to 18).

The semiconductor-embedded substrate having such a constitution has a first heat radiation member disposed opposite to the semiconductor device so that heat generated by the operation of the semiconductor device is easily transferred to the first heat radiation member. In addition, the first heat radiation member has a greater heat transfer coefficient or thermal conductivity than that of the insulating layer so that heat transferred to the first radiator portion is easily transferred and released to the circumference thereof (on the side opposite to the semiconductor device with the first heat radiation member therebetween). This makes it possible to bring about a sufficient heat radiation effect.

In addition, the first heat radiation member has an opening portion, in which at least one opening has been formed, at a site opposite to the semiconductor device, that is, a site which shows a relatively large temperature rise as a result of great heat conduction (heat flow, heat reflux) from the semiconductor device. When high heat is applied to the first heat radiation member and circumference thereof, the opening narrows by deformation owing to a difference in a linear thermal expansion coefficient between the insulating layer and first heat radiation member even if the thermal expansion of the first heat radiation member is greater than that of the insulating layer and the expanded portion is absorbed by the opening, whereby thermal stress acting on the first heat radiation member can be relaxed. This leads to prevention of deterioration of adhesion with the resin layer which will otherwise occur by the deformation or peeling of the first heat radiation member. The opening portion having a plurality of openings is more preferred because it can heighten the latitude of stress relaxation.

Semiconductor devices are typically in the form of a narrow strip or section (chip). Transistors, capacitors, amplifiers and other peripheral circuits are integrally formed on the plate surface so that heat generated by their action is radiated and transferred mainly to a direction opposite to the surface of the semiconductor devices. A temperature rise within a region opposite to the surface of the semiconductor device is relatively large compared with that around the region so that placement of the opening portion within the region is sufficient for relaxing the thermal stress. If the opening portion is not disposed around the region, heat release from the site can be promoted so that heat radiation properties can be improved further.

It is preferred to dispose a second heat radiation member which is disposed at a position, on the side opposite to the semiconductor device with the first heat radiation member therebetween, opposite to the opening portion of the first heat radiation member and has a greater heat transfer coefficient or thermal conductivity than that of the insulating layer.

In the above-described constitution, the heat which has been released from the first heat radiation member is transferred to the second heat radiation member and the heat transfer coefficient or thermal conductivity of the second heat radiation member is also greater than that of the insulating layer so that heat can be released to the exterior easily and heat radiation properties are improved further. This constitution is especially effective for a semiconductor-embedded substrate, such as a substrate having a multilayer wiring structure, having many insulating layers and a long heat release path from the semiconductor device. The second heat radiation member is disposed opposite to the opening portion of the first heat radiation member so that a heat flow from the semiconductor device which has passed through at least one opening formed in the opening portion is transferred to the second heat radiation member and then is released therefrom. This makes it possible to enhance the heat radiation properties of the whole substrate. Moreover, owing to disposal of the second heat radiation member, the semiconductor-embedded substrate can have enhanced rigidity and also have improved mechanical properties.

The second heat radiation member which is not opened at at least a site thereof opposite to the opening portion of the first heat radiation member is more preferred.

A heat flow from the first heat radiation member and a heat flow (heat flux) from the semiconductor device which has passed through at least one opening formed in the opening portion of the first heat radiation member can be transferred to the second heat radiation member without loss so that the resulting semiconductor-embedded substrate can have further enhanced heat radiation properties. In addition, the rigidity of the second heat radiation member itself increases compared with the second heat radiation member with openings therein. As a result, the resulting semiconductor-embedded substrate can have improved mechanical properties.

The second heat radiation member is arranged opposite to the semiconductor device with the first heat radiation member therebetween. A temperature rise of it during operation of the semiconductor device is not so large as that of the first heat radiation member so that thermal stress acting during the operation of the semiconductor device is smaller. Deformation or peeling of the second heat radiation member during operation of the semiconductor device can therefore be made smaller compared with that of the conventional one, resulting in prevention of deterioration of heat radiation properties during the operation.

A temperature rise of the second heat radiation member and thermal stress applied thereto during operation of the semiconductor device are smaller than those of the first heat radiation member. Even if the heat radiation properties of the second heat radiation member change by a high heat applied at the time of formation, the change does not have so much influence on the heat radiation properties of the whole substrate during the fabrication of the semiconductor device. In this point, the second heat radiation member may be not-opened at only a site thereof opposite to the opening portion of the first heat radiation member or the whole portion of the second heat radiation member may be a solid one without opening.

The semiconductor-embedded substrate according to the present invention preferably has a connection portion which is connected to the first heat radiation member and the second heat radiation member and has a greater heat transfer coefficient or thermal conductivity than that of the insulating layer, for example, a connection plug formed by filling a connecting hole such as via hole or through-hole with a material having a greater heat transfer coefficient or thermal conductivity than that of the insulating layer.

Such a constitution makes it possible to more efficiently transfer heat from the first heat radiation member to the second heat radiation member. Described specifically, since thermal conduction from the first heat radiation member to the second heat radiation member is promoted, the resulting semiconductor-embedded substrate can have further improved heat radiation properties. Disposal of such a connection portion is especially effective for the case where the second heat radiation member is disposed relatively apart from the first heat radiation member, for example, when the semiconductor-integrated substrate has a multi-level wiring structure; or in the case where plural second heat radiation members are arranged in a multistage structure.

In the opening portion of the first heat radiation member, the plural openings have been arranged preferably at certain (predetermined) gaps (intervals, pitches). All the gaps between the openings may be the same or different.

By arrangement of plural openings at certain gaps, a mesh pattern in which openings have been disposed uniformly as the sieve pores is formed at a site of the first heat radiation member opposite to the semiconductor device.

The term "mesh" usually means "mesh of a net", "fishnet" or "sieve pores" (Kojien, fifth-edition), but the term "mesh" as used herein is not limited to plural openings arranged in a simple matrix or array form like mesh of a net woven vertically and horizontally (in other words, in the form of a lattice), that is, arrangement of openings that can be expressed by an orthogonal coordinate system (for example, X-Y coordinate). Plural openings are arranged radially as described later (arrangement of openings that can be expressed by a polar coordinate system); or arranged radially and circumferentially (concentrically arranged openings belong to so-called "web-like" mesh. Such a "web-like" mesh is also embraced in the "radial" mesh in the present invention. When the first heat radiation member is not in the form of a flat plate but in the form of a curved plate, for example, spherical plate, openings may be arranged in a pattern that can be expressed by a polar coordinate (spherical coordinate) system.

As described above, the openings function so as to absorb the thermally expanded portion of the first heat radiator potion so that uniform arrangement of the openings in a predetermined pattern equalizes stress relaxation at the first heat radiation member. This effectively suppresses deterioration in adhesion between the first radiator portion and resin layer owing to the local deformation or peeling of the first heat radiation member. When the heat (heat flux) distribution around the semiconductor device is almost uniform or a heat gradient is almost flat, stress relaxation at the first heat radiation member can be made uniform further by using for the first heat radiation member a lattice-like pattern in which a pitch between the openings is constant.

A semiconductor device having a high operating frequency such as digital IC tends to be a noise source of harmonic radiation. High density mounting of many electronic parts on a narrow space as in a portable appliance such as mobile phone, harmonic radiation noise emitted from the semiconductor device poses a serious problem. A CDMA (Code Division Multiple Access) system recently employed in mobile phones is resistant to fading and shows a high efficiency in the use of frequency, but by its nature, superposition of noise from another semiconductor device tends to occur because it uses a very wide band frequency. At the same time, once it occurs, it cannot be removed easily. A semiconductor-embedded substrate used for a CDMA mobile phone is therefore requested to have very high EMC (Electromagnetic Compatibility).

The semiconductor-embedded substrate having the first heat radiation member - having an opening portion in which plural openings have been arranged at certain gaps and a mesh pattern has been defined as described above - arranged opposite to the semiconductor device has excellent harmonic-radiation-noise blocking properties, when the first heat radiation member is made of a conductor such as metal. In this case, the number and shape of the openings, arrangement gaps, and arrangement pattern can be determined as needed depending on the operating frequency of the semiconductor device. For example, assuming that the inverse of the frequency of harmonic radiation noise emitted by the semiconductor device is λ, the harmonic-radiation-noise blocking properties can be enhanced considerably by setting respective diameters of the openings or average thereof to preferably λ/16 or less, more preferably λ/64 or less.

The opening portion of the first heat radiation member has a plurality of radially arranged openings. The opening extending in one direction are divided into plural openings. Described specifically, a plurality of openings are provided in a row in one direction to form so called one radial opening and a plurality of such radial openings may extend radially in directions different in a predetermined angle. In this case, a web-like mesh pattern as described above or analogous thereto is formed.

When a plurality of openings are arranged radially from a position corresponding to a substantial center of the first heat radiation member and opposite to the semiconductor device, a site between the openings will be a heat conduction path extending outward from the substantial center. The amount of heat from the center portion of the semiconductor device is usually greatest so that a temperature rise at the substantial center of the first heat radiation member opposite to the center portion of the semiconductor device becomes relatively high. By securing the conduction path of heat from the high-temperature substantial center to the circumference, heat release from the first heat radiation member is promoted further, resulting in further improvement in the heat radiation properties.

The first heat radiation member having an opening portion with a plurality of concentrically arranged openings is not forming a part of the present invention. The openings may each have a circular, rectangular or another shape insofar as it is in the form permitting concentric arrangement, that is, in the form of an endless or finite loop. Openings in the form of an endless loop are preferably similar to each other, because it facilitates concentric arrangement.

When in the opening portion of the first heat radiation member, a plurality of openings is arranged concentrically, concentrically arranged patterns are also defined at the sites between these openings. And, this first heat radiation member, if made of a conductor such as metal, can further improve the blocking properties of harmonic radiation noise generated from the semiconductor device.

The openings employing both concentric arrangement and radial arrangement are still more preferred. A plurality of openings arranged linearly and radially at certain gaps constitute, as described above, a radial opening unit. When a plurality of radial opening units are formed, a concentric and radial arrangement pattern is formed between the openings. This is just a "web-like" mesh pattern as described above and enables to enhance both the heat radiation properties and harmonic-radiation-noise blocking properties.

In addition, the first heat radiation member connected to the semiconductor device directly or indirectly via a member having a greater heat transfer coefficient or thermal conductivity than that of the insulator is preferred.

This increases the heat transfer amount from the semiconductor device to the first heat radiation member, whereby the resulting semiconductor-embedded substrate can have further enhanced heat radiation properties.

More specifically, the semiconductor-embedded substrate comprising a plate-like semiconductor device with a bump formed on one side thereof, and a first heat radiation member disposed opposite to the other surface of the semiconductor device is useful.

When the semiconductor-embedded substrate is used as a module substrate, BGA (Ball Grid Array) terminals are effective because the substrate must satisfy a request for further downsizing and increase in terminals (pin). In this case, a bump (stud bump, stud pad) formed on the semiconductor device is connected to BGA terminals. Arrangement of a heat radiation means such as radiator plate on the bump formation side of the semiconductor device is not preferred because it limits the number of terminals and disturbs downsizing of a module substrate. Heat radiation from the side opposite to the bump formation surface is therefore required. Accordingly, the semiconductor-embedded substrate of the present invention having the first heat radiation member disposed opposite to the surface of the semiconductor substrate with no bump formed thereon is especially suited as a module substrate.

A fabrication process of the semiconductor-embedded substrate according to the present invention is effectively used for the fabrication of the above-described semiconductor-embedded substrate of the present invention. It is equipped with a first step of forming a first heat radiation member, on at least one side of a semiconductor device and opposite thereto, having an opening portion in which a plurality of openings have been formed at a site opposite to the semiconductor device, and having a greater heat transfer coefficient or thermal conductivity than that of an insulating layer.

The fabrication process preferably has a second step of forming a second heat radiation member, on the side opposite to the semiconductor device with the first heat radiation member therebetween, having a greater heat transfer coefficient or thermal conductivity than that of the insulating layer so as to be opposite to the opening portion of the first heat radiation member.

The first heat radiation member may be formed either before or after embedding of the semiconductor device in the insulating layer. More specifically, when the formation of the first heat radiation member is performed prior to the embedding of the semiconductor device in the insulating layer, it is only necessary to successively carry out a step of forming a film of a predetermined thickness on a predetermined base layer while using a material for forming the first heat radiation member; a step of making at least one opening in the film to form the first heat radiation member having an opening portion; a step of placing a semiconductor device on or above the first heat radiation member, and then a step of stacking an insulating layer of a predetermined thickness on the first heat radiation member.

When the formation of the first heat radiation member is performed after the embedding of the semiconductor device in the insulating film, on the other hand, it is only necessary to successively carry out a step of placing the semiconductor device on or over a predetermined base layer; a step of stacking an insulating layer of a predetermined thickness on the base layer; a step of forming a film of a predetermined thickness on the insulating layer while using a material for forming the first heat radiation member; and then a step of making at least one opening in the film to form the first heat radiation member having an opening portion.

According to the present invention, since the first heat radiation member is placed opposite to the semiconductor device, which permits transfer of the heat generated in the semiconductor device to the first heat radiation member, and it has a greater heat transfer coefficient or thermal conductivity than that of the insulating layer, the resulting semiconductor-embedded substrate can have satisfactory heat radiation properties. In addition, one or more openings have been formed in the opening portion of the first heat radiation member so that even if heat is applied to the first heat radiation member or circumference thereof and the first heat radiation member is expanded during fabrication or operation, the opening narrowed by deformation absorbs the expanded portion, making it possible to relax a thermal stress acting on the first heat radiation member. As a result, it becomes possible to fabricate a semiconductor-embedded substrate having satisfactory heat radiation properties and high reliability.

### BRIEF DESCRIPTION OF DRAWINGS

FIG. 1 is a cross-sectional view illustrating the essential portion of a semiconductor-embedded substrate according to a first embodiment of the present invention;
FIG. 2 is a cross-sectional view illustrating the essential portion of a semiconductor-embedded substrate according to a second embodiment of the present invention;
FIG. 3 is a cross-sectional view illustrating the essential portion of a semiconductor-embedded substrate according to a third embodiment of the present invention;
FIG. 4 is a cross-sectional view illustrating the essential portion of a semiconductor-embedded substrate according to a fourth embodiment of the present invention;
FIGS. 5A to 5E are schematic views illustrating the manufacturing steps of a semiconductor-embedded substrate 400;
FIG. 6 is a plan view taken along a line VI-VI of FIG. 4;
FIG. 7 is a plan view taken along a line VII-VII of FIG. 4 the shape not forming part of the invention but useful for understanding it;
FIG. 8 is a plan view taken along a line VIII-VIII of FIG. 4;
FIG. 9 is a plan view taken along a line IX-IX of FIG. 4;
FIG. 10 is a cross-sectional view illustrating the essential portion of a semiconductor-embedded substrate according to a fifth embodiment of the present invention;
FIG. 11 is a perspective view illustrating a schematic structure of a semiconductor device 30;
FIG. 12 is a plan view illustrating a modified example of the first heat radiation member of the semiconductor-embedded substrate, not forming a part of the present invention;
FIG. 13 is a plan view illustrating another modified embodiment of the first heat radiation member of the semiconductor-embedded substrate, not forming a part of the present invention;
FIG. 14 is a plan view illustrating a further modified embodiment of the first heat radiation member of the semiconductor-embedded substrate, not forming a part of the present invention;
FIG. 15 is a plan view illustrating a embodiment of the first heat radiation member of the semiconductor-embedded substrate according to the present invention;
FIG. 16 (not forming part of the present invention) is a plan view illustrating a heat transfer analytical, in simulation, of a heat radiation member having an opening portion in which rectangular or circular openings have been formed;
FIG. 17 is a cross-sectional view taken along a line XVII-XVII of FIG. 16;
FIG. 18 is a graph illustrating analysis results of a temperature rise ΔT (°C) at a center portion of a semiconductor device with respect to an opening ratio (%) of four opening patterns; and
FIG. 19 is a plan view illustrating one embodiment of a first heat radiation member having an opening portion in which a combination of a radial opening pattern and a concentric opening pattern has been formed.

### DETAILED DESCRIPTION OF THE INVENTION

Embodiments of the present invention will hereinafter be described specifically. Elements of a like function will be identified by like reference numerals and overlapping descriptions will be omitted. Note that positional relationships such as above, below, left and right are based on the positional relationships shown in the drawings unless otherwise specifically indicated. Further, dimensional proportions in the drawings are not limited to those illustrated in the drawings. The following embodiments are merely for the purpose of illustrating the present invention and are not to be construed as limiting the invention. Moreover, various modifications and changes may be made to the present invention without departing from the scope of the present invention.

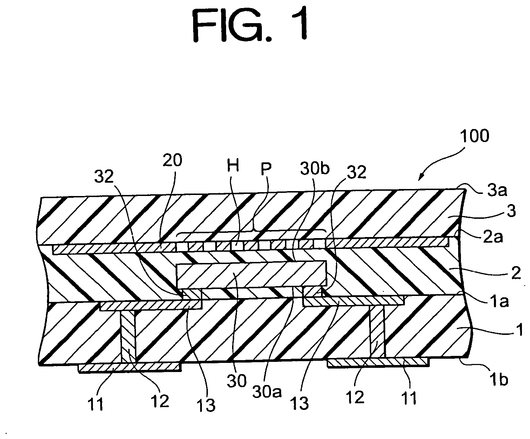

FIG. 1 is a cross-sectional view showing the essential portion of a semiconductor-embedded substrate according to a first embodiment of the present invention. The semiconductor-embedded substrate 100 is a three-layer substrate having, as an electric insulating layer, resin layers 1, 2 and 3 stacked one after another. The resin layer 1 has, on the illustrated lower surface 1b thereof, terminal electrodes 11 and 11 such as GBA terminals for external connection. The resin layer 1 has, at the surface layer of the illustrated upper layer 1a thereof and at the same time, on the illustrated lower surface of the resin layer 2, internal wirings 13 and 13 made of a conductor such as metal. These terminal electrodes 11 and 11 and internal wirings 13 and 13 are electrically connected via respective connection plugs 12 and 12 formed by filling a conductor such as a metal in a connecting hole such as via hole penetrating through the resin layer 1. The resin layer 2 is embedded with a semiconductor device 30.

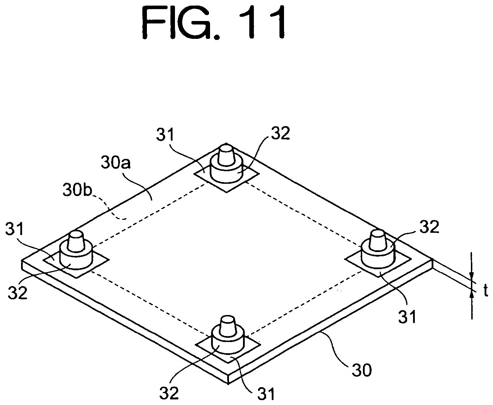

FIG. 11 is a schematic perspective view illustrating the structure of the semiconductor device 30. The semiconductor device 30 is a semiconductor part such as semiconductor IC (die) in the form of a bare chip and it has, on the main surface 30a thereof in the form of a rectangular plate, many land electrodes 31. In this diagram, the land electrodes 31 and bumps 32 which will be described later are illustrated at four corners and other land electrodes 31 are not illustrated. Although no particular limitation is imposed on the kind of the semiconductor device 30, examples include digital ICs having an extremely high operating frequency such as CPU and DSP.

In addition, no particular limitation is imposed, but the back surface 30b of the semiconductor device 30 is polished, by which the thickness t (distance from the main surface 30a to the back surface 30b) of the semiconductor device 30 is made thinner than that of the conventional semiconductor device. The thickness is preferably 200 µm or less, more preferably from about 20 to 50 µm. In order to thin the semiconductor device 30, the back surface 30b is subjected to preferably surface roughening treatment such as etching, plasma treatment, laser exposure, blast polishing, buff polishing or chemical treatment.

Polishing of the back surface 30b of the semiconductor device 30 is preferably carried out simultaneously for many semiconductor devices in the form of a wafer and then separating the wafer into individual semiconductor devices 30 by dicing. When the wafer is diced and separated into the individual semiconductor devices 30 prior to thinning by polishing, the back surface 30b can be polished while covering the main surface 30a of the semiconductor device 30 with a thermosetting resin or the like.

On each of the land electrodes 31, the bump 32, one of conductive protrusions, is formed. No particular limitation is imposed on the bump 32 and various bumps such as stud bump, plate bump, plated bump and ball bump are usable. A stud bump is shown in the diagram. When a stud bump is employed as the bump 32, it can be formed by wire bonding of silver (Ag) or copper (Cu). When a plate bump is employed, it can be formed by plating, sputtering or vapor deposition. When a plated bump is employed, it can be formed by plating. When a ball bump is employed, it can be formed by placing a solder ball on the land electrode 31 and then melting it or printing a solder cream on the land electrode and then melting it. A conical or columnar bump obtained by screen printing a conductive material and then curing it or a bump obtained by printing a nanopaste and then sintering it by heating is also usable.

A metal usable for the bump 32 is not particularly limited and examples of it include gold (Au), silver (Ag), copper (Cu), nickel (Ni), tin (Sn), chromium (Cr), nickel-chromium alloy and solder. Of these, use of copper is preferred. When the bump 32 is made of copper, bond strength to the land electrode 31 can be made higher than that of the bump made of, for example, gold and the semiconductor device 30 has enhanced reliability.

The dimension and shape of the bump 32 can be set as needed depending on the gap (interval, pitch) between the land electrodes 31. When the pitch of the land electrodes 31 is about 100 pm, it is only necessary to form the bump electrode 32 having a maximum diameter of from about 10 to 90 µm and height of from about 2 to 100 µm. It is to be noted that the bump 32 can be bonded to each land electrode 31 by a wire bonder after a wafer is diced and separated into individual semiconductor devices 30.

The semiconductor device 30 having such a constitution is placed in the resin layer 2 with the bumps 32 being electrically connected to the internal wirings 13, respectively (FIG. 1).

At a position at the surface layer of the illustrated upper layer 2a of the resin layer 2 and on the illustrated lower surface of the resin layer 3 and at the same time opposite to the back surface 30b of the semiconductor device 30, a heat radiation member 20 (first heat radiation member) in the plate form is placed. This heat radiation member 20 has a plane area greater than that of the semiconductor device 30 so that it is placed to cover the semiconductor device 30 when viewed from the illustrated upper portion in the diagram of the semiconductor-embedded substrate 100. In a region of the heat radiation member 20 just above and opposite to the back surface 30b of the semiconductor device 30, an opening portion P having therein at least one, preferably a plurality of openings H is formed. No particular limitation is imposed on the material of the heat radiation member 20 insofar as it has a heat transfer coefficient or thermal conductivity greater than that of the resin layer 2. Examples of the material include metals such as gold (Au), silver (Ag), copper (Cu), nickel (Ni), tin (Sn), chromium (Cr), aluminum (Al) and tungsten (W). Of these, copper is preferred from the standpoints of conductivity and cost.

Specific examples of the material used for the resin layers 1, 2 and 3 include simple resins such as vinyl benzyl resin, polyvinyl benzyl ether compound resin, bismaleimide triazine resin (BT resin), polyphenylene ether (polyphenylene ether oxide) resin (PPE, PPO), cyanate ester resin, epoxy + active ester curable resin, polyphenylene ether resin (polyphenylene oxide resin), curable polyolefin resin, benzocyclobutene resin, polyimide resin, aromatic polyester resin, aromatic liquid crystal polyester resin, polyphenylene sulfide resin, polyetherimide resin, polyacrylate resin, polyether ether ketone resin, fluorine resin, epoxy resin, phenol resin and benzoxazine resin; materials obtained by adding, to these resins, silica, talc, calcium carbonate, magnesium carbonate, aluminum hydroxide, magnesium hydroxide, aluminum borate whisker, potassium titanate fibers, alumina, glass flakes, glass fibers, tantalum nitride or aluminum nitride; materials obtained by adding, to these resins, metal oxide powder containing at least one metal selected from magnesium, silicon, titanium, zinc, calcium, strontium, zirconium, tin, neodymium, samarium, aluminum, bismuth, lead, lanthanum, lithium or tantalum; materials obtained by incorporating, in these resins, glass fibers or resin fibers such as aramid fibers; and materials obtained by impregnating these resins in a glass cloth, aramid fibers, or nonwoven fabric. A proper one is selected as needed from the viewpoints of electric properties, mechanical properties, water absorption, reflow resistance and the like.

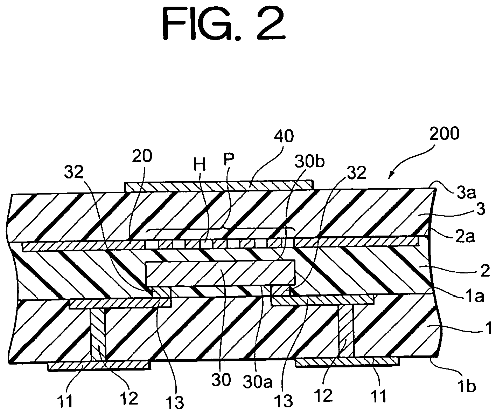

FIG. 2 is a cross-sectional view illustrating the essential portion of a semiconductor-embedded substrate according to a second embodiment of the present invention. This semiconductor-embedded substrate 200 has a similar constitution to that of the semiconductor-embedded substrate 100 shown in FIG. 1 except that it is equipped with a not-opened, that is, solid heat radiation member 40 (second heat radiation member) at a position opposite to the opening portion P of the heat radiation member 20 on the other surface (illustrated upper surface) of the resin layer 3. No particular limitation is imposed on the material of the heat radiation member 4.0 insofar as it has a greater heat transfer coefficient or thermal conductivity than that of the resin layers 2 and 3. Examples include metals such as gold (Au), silver (Ag), copper (Cu), nickel (Ni), tin (Sn), chromium (Cr), aluminum (Al) and tungsten (W). Of these, copper is preferred from the standpoints of conductivity and cost.

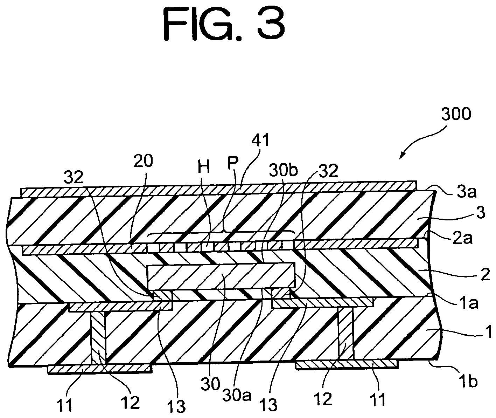

FIG. 3 is a cross-sectional view illustrating the essential portion of a semiconductor-embedded substrate according to a third embodiment of the present invention. The semiconductor-embedded substrate 300 has a similar constitution to that of the semiconductor-embedded substrate 200 illustrated in FIG. 2 except that it is equipped with, instead of the heat radiation member 40, a heat radiation member 41 (second heat radiation member) having a greater area than the heat radiation member 40 and having no openings (solid). The heat radiation member 41 is also made of a similar material to that of the heat radiation member 40.

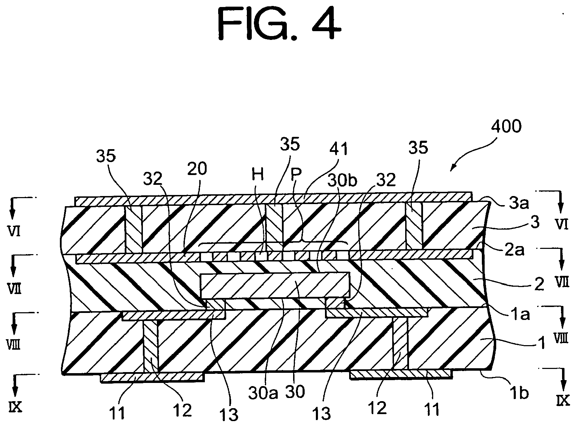

FIG. 4 is a cross-sectional view showing the essential portion of a semiconductor-embedded substrate according to a fourth embodiment of the present invention. The semiconductor-embedded substrate 400 has a similar constitution to that of the semiconductor-embedded substrate 300 shown in FIG. 3 except that a connection plug 35 is connected to both the heat radiation member 20 and heat radiation member 41. This connection plug 35 is formed by filling a conductor such as metal in a connecting hole such as via hole extending through the resin layer 3.

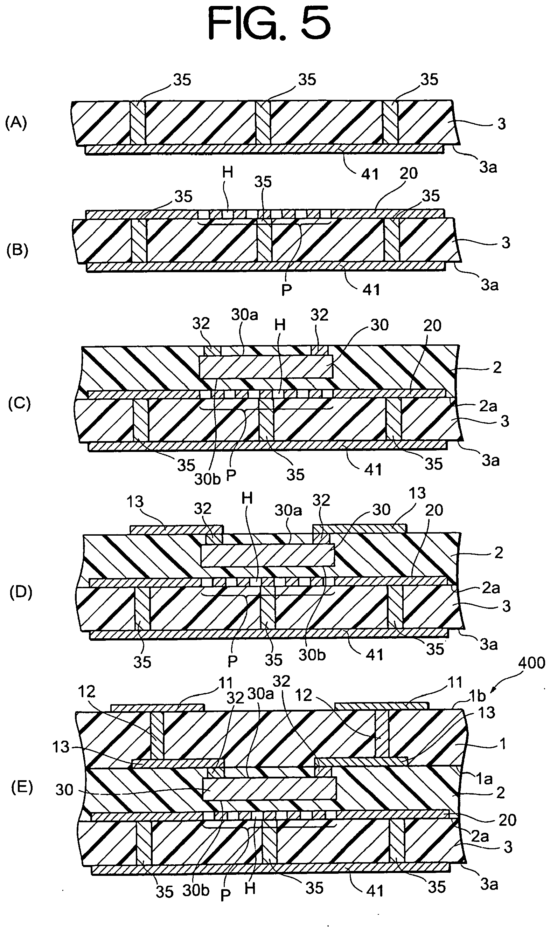

A fabrication process of a semiconductor-embedded substrate will hereinafter be described while using the semiconductor-embedded substrate 400 illustrated in FIG. 4 as an example. FIGS. 5A to 5E are schematic views illustrating the fabrication steps of the semiconductor-embedded substrate 400. The procedures shown in this Embodiment are those of a process for fabricating the semiconductor-embedded substrate 400 with the main surface 30a of the semiconductor device 30 up vertically (which will hereinafter be called "face"). The term "face down" is used when fabrication is performed with the main surface 30a of the semiconductor device down vertically as shown in FIG. 4.

First, a heat radiation member 41 is formed on one surface of the resin layer 3 by forming a material metal film of the heat radiation member 41 in a known manner such as vapor-phase growth, electroless plating or vapor deposition and patterning the film by removing portions other than the heat radiation member 41 by etching, ablation or the like (second step). After a mask is formed, for example, by applying a resist to the other surface of the resin layer 3 and exposing and developing it through a prescribed mask pattern, a via hole for a connection plug 35 is made by wet etching, dry etching or the like. After removal of the mask pattern, a material metal of the connection plug 35 is filled in the via hole by vapor phase growth or the like to form the connection plug 35 (FIG. 5A). An unnecessary metal, if any, on the other surface except the via hole is removed.

A material metal film of a heat radiation member 20 is then formed on the other surface of the resin layer 3 in a known manner such as vapor phase growth, electroplating, vapor deposition or the like. After formation of a mask by exposure and development of the film while using a mask pattern corresponding to the whole shape of the opening portion p and an arrangement pattern of the openings H in the opening P, the film is patterned by wet etching, dry etching or the like, whereby the heat radiation member 20 having the opening portion P is formed (FIG 5B; first step).

On the resin layer 3 having the heat radiation member 20 formed thereon, an uncured or semi-cured resin layer 2 is stacked and in this layer, the semiconductor device 30 is placed with face up and so as to expose the bump 32 from the illustrated upper surface of the resin layer 2. Then, the resin layer 2 is cured (FIG. 5C). A metal film is formed and patterned so as to connect an internal wiring 13 to the bump 32 of the semiconductor device 30 (FIG. 5D). On the resin layer 2 having the internal wiring 13 formed thereon, an uncured or semi-cured resin layer 1 is stacked and cured. A via hole for a connection plug 12 is made in the resin layer 1 and a material metal of the connection plug 12 is filled in the via hole to form the connection plug 12. Terminal electrodes 11 and 11 such as BGA terminals are bonded to the resin layer 3 at the positions of the connection plugs 12 and 12, whereby the semiconductor-embedded substrate 400 which is the upside-down substrate of FIG. 4 is fabricated (FIG. 5E).

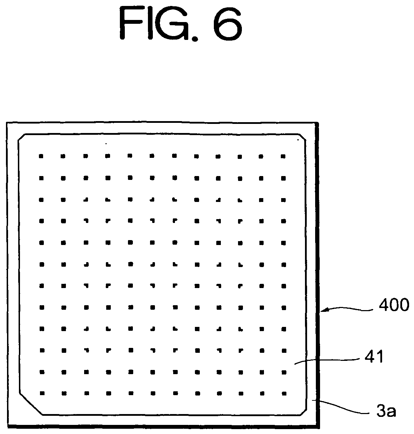

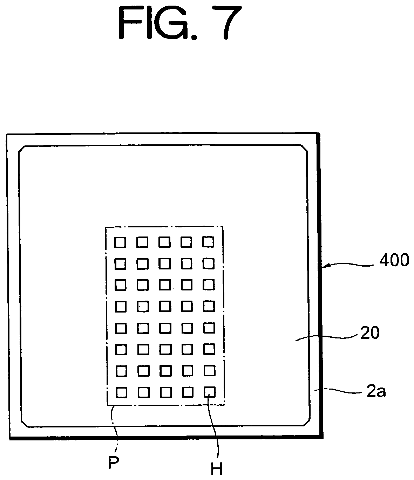

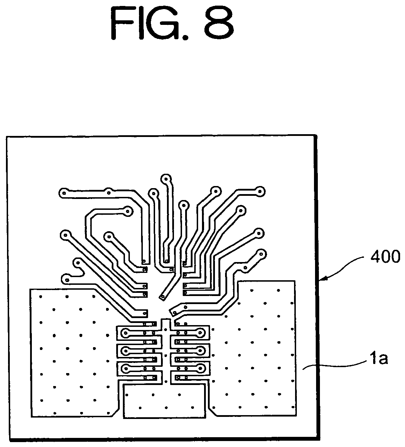

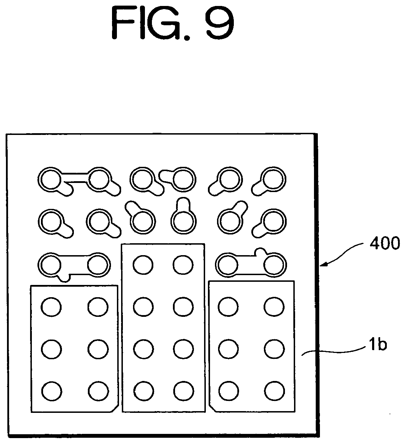

The thus-fabricated semiconductor-embedded substrate 400 at positions in a stacking direction will be shown in FIGS. 6 to 9, respectively. FIG. 6 is a plan view taken along a line VI-VI of FIG. 4 and it illustrates the arrangement of the solid heat radiation member 41. FIG. 7 is a plan view taken along a line VII-VII of FIG. 4 and it illustrates the arrangement of the heat radiation member 20 having an opening portion P in which rectangular openings H are arranged in the array form (matrix form) at certain gaps. FIG. 8 is a plan view taken along a line VIII-VIII of FIG. 4 and it illustrates the arrangement of wirings including internal wirings 13. FIG. 9 is a plan view taken along a line IX-IX of FIG. 4 and it illustrates the arrangement of the terminal electrodes 11 such as BGA terminal.

In the semiconductor-embedded substrates 100, 200, 300 and 400 having such a constitution, the heat radiation member 20 is placed opposite to and immediately above the semiconductor device 30 so that heat generated in the semiconductor device 30 is easily transferred to their heat radiation member 20. In addition, the heat radiation member 20 has a greater heat transfer coefficient or thermal conductivity than the resin layer 2 so that heat transferred to the heat radiation member 20 tends to be released outside from the circumference thereof, particularly, from the side of the resin layer 3. The structure with such a heat radiation member 20 therefore enables to provide a sufficient heat radiation effect.

In the heat radiation member 20, the opening portion P having at least one opening H formed therein is placed at a site opposite to the semiconductor device 30, that is, at a site that undergoes a relatively large temperature rise due to heat transfer (heat flow, heat flux) from the semiconductor device 30. When high heat is applied to the heat radiation member 20 and circumference thereof, the opening H absorbs an expanded portion by narrowing its shape, which occurs due to a difference in the linear thermal coefficient between the resin layer 2 and heat radiation member 20 even if the thermal expansion at the heat radiation member 20 is greater. Thermal stress acting on the heat radiation member 20 can therefore be relaxed. Accordingly, even if treatment of applying high heat such as reflow is performed during fabrication or the semiconductor device 30 generates high heat, deterioration in the adhesion between the heat radiation member 20 and resin layer 2 can be prevented, whereby reduction in a production yield can be prevented and reliability of products can be improved.

In the semiconductor-embedded substrates 200 and 300, the heat radiation members 40 and 41 are placed at a position immediately above the heat radiation member 20 and opposite to the opening portion P of the heat radiation member 20. Heat released from the heat radiation member 20 is transferred further to the heat radiation members 40 and 41. Since a heat transfer coefficient or thermal conductivity of these heat radiation members 40 and 41 is greater than that of the resin layers 2 and 3, these substrates can have further improved heat radiation properties, respectively. Moreover, the heat radiation members 40 and 41 are disposed at a position opposite to and immediately above the opening portion P of the heat radiation member 20 so that heat flow that has originated from the semiconductor device 30 and passed through at least one opening H formed in the opening portion P is transferred to the heat radiation members 40 and 41, from which the heat can be released. It is therefore possible to enhance the heat radiation properties of the whole substrate further.

Such a structure equipped with the heat radiation member 40 is particularly effective when employed for a semiconductor-embedded substrate having many insulating layers as in a multi-level wiring structure and having a long heat radiation path from the semiconductor device 30. The semiconductor-embedded substrates 200 and 300 can have enhanced rigidity by having the heat radiation member 40. This leads to improvement of mechanical properties and further improvement in the reliability of products.

Moreover, the heat radiation members 40 and 41 are, at the site thereof opposite to the opening portion P of the heat radiation member 20, solid without opening so that a heat flow from the heat radiation member 20 and a heat flow that has originated from the semiconductor device 30 and passed through at least one opening H formed in the opening portion P of the heat radiation member 20 are transferred to the heat radiation members 40 and 41 without loss. This enables to enhance the heat radiation properties further. In addition, the rigidity of the heat radiation members 40 and 41 themselves increases compared with that when they have an opening so that the semiconductor-embedded substrates 200 and 300 can have further improved mechanical properties.

In the semiconductor-embedded substrate 400, the heat radiation member 20 and heat radiation member 41 are connected via the connection plug 35. Since the connection plug 35 has also a greater heat transfer coefficient or thermal conductivity than that of the resin layers 2 and 3 so that heat from the heat radiation member 20 can be transferred efficiently to the heat radiation member 41. In short, the substrate can have further improved heat radiation properties because thermal conduction from the heat radiation member 20 to the heat radiation member 40 is accelerated. Such a structure in which the heat radiation member 20 and heat radiation member 40 are thermally connected is also particularly effective when employed for a semiconductor-embedded substrate having many insulating layers as in a multi-level wiring structure and having a long heat radiation path from the semiconductor device 30. Moreover, it is useful further when the heat radiation member 40 is disposed relatively apart from the heat radiation member 20 or a plurality of the heat radiation members 40 are arranged as a multistage structure.

In addition, the opening portion P of the heat radiation member 20 has a plurality of openings H arranged in an array form at a certain pitch as illustrated in FIG. 7. The openings H arranged in such a manner therefore define a mesh pattern as if they are arranged regularly as sieve pores. Since the openings H are arranged regularly, thermally expanded portion of the heat radiation member 20 can be absorbed uniformly by them. This leads to uniform stress relaxation at the first heat radiation member. It is therefore possible to effectively prevent deterioration of adhesion with the resin layer 2 which will otherwise occur by the local deformation or peeling of the heat radiation member 20. In addition, the heat radiation member 20 made of a conductor and having such a mesh pattern can prevent diffusion of harmonic radiation noise to the exterior so that the resulting semiconductor-embedded substrate can have improved EMC.

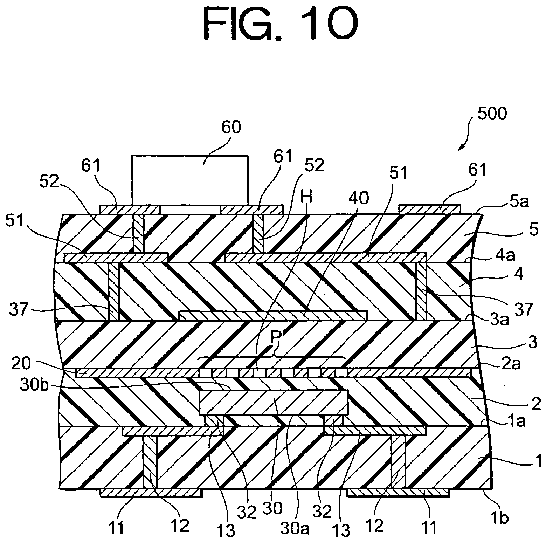

FIG. 10 is a cross-sectional view illustrating the essential portion of a semiconductor-embedded substrate according to a fifth embodiment of the present invention. One example of a semiconductor-embedded substrate having a wiring structure with more layers is shown in this Embodiment. A semiconductor-embedded substrate 500 has five resin layers 1 to 5 stacked one after another and the resin layers 1 to 3 have a substantially similar structure to that of the semiconductor-embedded substrate 200 shown in FIG. 2. A heat radiation member 40 formed on the illustrated upper surface 3a of the resin layer 3 is placed in the resin layer 4 and the resin layer 4 has, on the illustrated upper surface 4a thereof, internal wirings 51 and 51.

The internal wiring 51 is electrically connected to a predetermined layer (not illustrated) by a connecting wiring 37 obtained by filling a conductor such as metal in a connecting hole such as through-hole extending through the resin layer 4. The internal wirings 51 and 51 are placed in the resin layer 5 and on the illustrated upper surface 5a of the resin layer 5 which is the uppermost layer, wirings 61 and 61 are placed. These wirings 61 and 61 and internal wirings 51 and 51 are electrically connected respectively via connection plugs 52 and 52 formed by filling a conductor such as a metal in a connecting hole such as via hole extending through the resin layer 5. On the wirings 61 and 61, passive components 60 such as capacitor are mounted.

The semiconductor-embedded substrate 500 having such a constitution is also equipped with a heat radiation member 20 having an opening P at a position immediately above and opposite to the back surface 30b of the semiconductor device 30 and further with a heat radiation member 40 arranged above and opposite to the heat radiation member 20 so that it can exhibit sufficient radiation properties. The semiconductor-embedded substrates 100, 200, 300, 400 and 500 each can dissipate heat from the side of the back surface 30b because the heat radiation member 20 is placed on the side of the back surface 30b having no bump of the semiconductor device 30 formed thereon. They can therefore employ BGA terminals as terminal electrodes 11 and 11. Accordingly, the semiconductor-embedded substrates 100, 200, 300, 400 and 500 are extremely useful as a module substrate requested to realize further downsizing and reduction in the number of terminals.

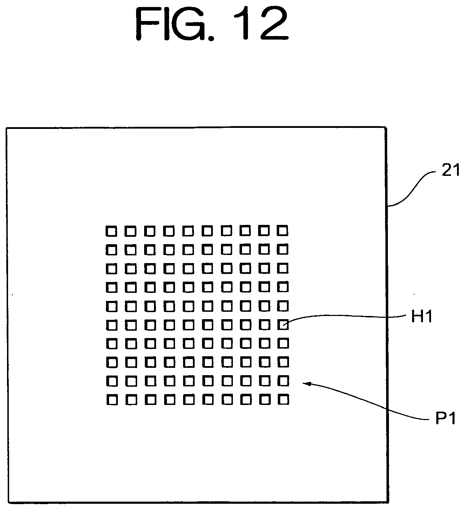

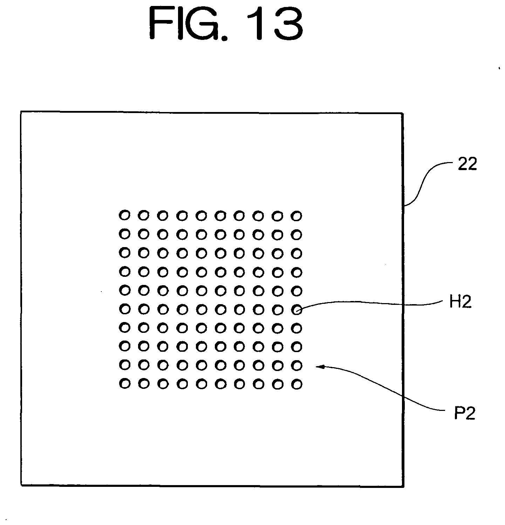

FIGS. 12-14 and 16 are each a plan view illustrating a modified example, not forming part of the invention, of the first heat radiation member which the semiconductor-embedded substrate has. FIG. 12 illustrates a heat radiation member 21 having an opening portion P1 in which the same number of rectangular openings H1 similar to those of the heat radiation member 20 has been arranged vertically and horizontally in an array form. In the opening P1, a mesh pattern with the openings H1 arranged regularly as sieve pores is defined. FIG. 13 illustrates a heat radiation member 22 having an opening portion P2 in which the same number of circular openings H1 has been arranged vertically and horizontally in an array form. Also in this case, in the opening P2, a mesh pattern with the openings H2 arranged regularly as sieve pores is defined.

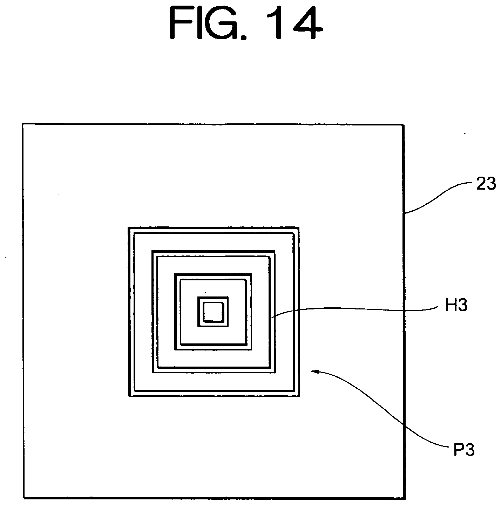

FIG. 14 illustrates a heat radiation member 23 having an opening portion P3 in which a plurality of endless rectangular loop openings H3 have been arranged concentrically around the center portion (portion coaxial with the center of the semiconductor device 30) of the heat radiation member 23. The openings H3 have a similar shape each other. In this heat radiation member 23, sites between the openings H3 also define a concentrically arranged pattern similar to the openings H3. It has been elucidated by the finding of the present inventors that when the heat radiation member 23 having such a pattern is made of a conductor such as metal, the resulting semiconductor-embedded substrate can have improved blocking properties of harmonic-radiation-noise generated in the semiconductor device 30 than the heat radiation member in a mesh pattern.

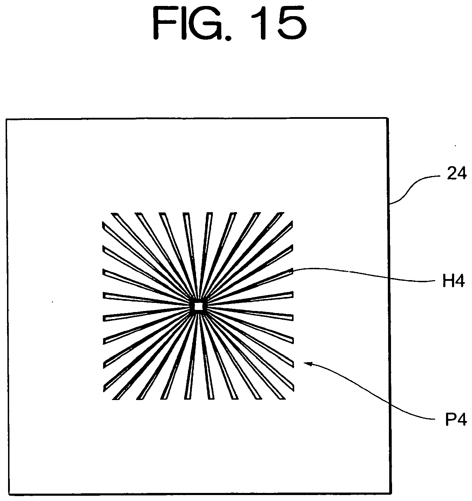

FIG. 15 illustrates a heat radiation member 24 having an opening portion P4 in which a plurality of wedge-shaped openings H4 is arranged radially around the center portion (coaxial with the center portion of the semiconductor device 30) of the heat radiation member 24. Sites between these openings H4 will be a heat transfer path extending from the center portion of the heat radiation member 24 to the circumference thereof. The heat amount from the center portion of the semiconductor device 30 tends to be highest so that a temperature rise at the center portion of the heat radiation member 24 opposite to the center portion of the semiconductor device 30 becomes relatively large. Since the heat transfer path is defined to extend from the center portion of the heat radiation member 24, which becomes hot by the heat, to the circumference thereof, heat release from the heat radiation portion 24 is promoted further, resulting in improvement of heat radiation properties.

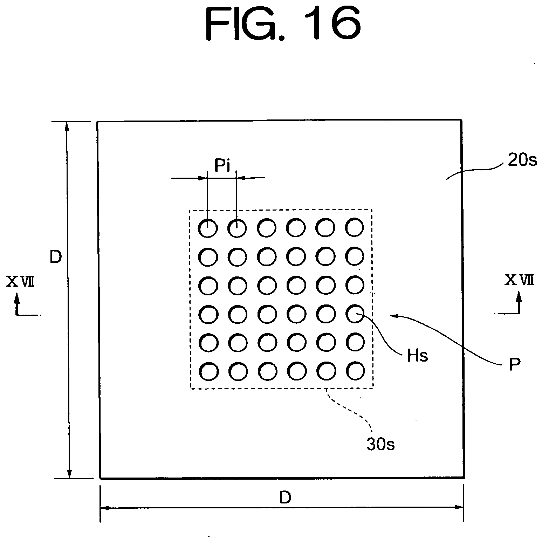

The present inventors carried out heat transfer analysis of the four opening patterns of the heat radiation portions 21 to 24 illustrated in FIGS. 12 to 15 by using the finite element method and ran simulation of heat radiation properties of the heat radiation portions 21 to 24, respectively. FIG. 16 is a plan view illustrating a heat transfer analytical model, in simulation, of a heat radiation portion having a rectangular or circular opening portion. The outer dimension D of a heat radiation member 20s was set to 10 mm, the outer dimension of a semiconductor device 30s was set to 5 mm x 5 mm, and thickness thereof was set to 50 µm. The dimension of the opening portion Ps was made equal to the outer dimension of the semiconductor device 30s. Inside of the opening portion Ps, 10 (row) x 10 (column) of openings Hs were arranged at a pitch Pi of 0.5 mm and thus the opening portion Ps was formed. An opening ratio of the opening Ps, a variation parameter, was adjusted to be from 0 to 100% by changing the area of the openings Hs. Also in a heat transfer analytical model of a heat radiation portion having an opening portion in which openings are arranged concentrically or radially, the opening ratio was adjusted to fall within a range of from 0 to 100%.

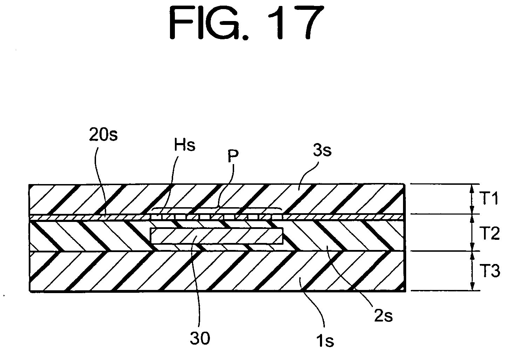

FIG. 17 is a cross-sectional view illustrating a heat transfer analytical model of a semiconductor-embedded substrate having the heat radiation member 20s. It is a cross-sectional view taken along a line XVII-XVII of FIG. 16. In this model, the semiconductor device 30s is embedded in the resin layer 2s of three resin layers 1s, 2s and 3s stacked one after another. It has the heat radiation member 20s between the resin layer 2s and resin layer 3s. The thicknesses T1, T2 and T3 of the resin layers 1s, 2s and 3s were set to 40 pm, 122 µm and 40 µm, respectively while the heat radiation member 20s was made of copper (Cu) having a thickness of 12 µm. The amount of heat generated by the semiconductor device 30s was set to 1 W. The lower surface temperature of the resin layer 1s was kept constant at 25°C and the initial ambient temperature was also set to 25°C. The heat transfer coefficient of the resin layers 1s, 2s and 3s was set to 4.5 w/m².

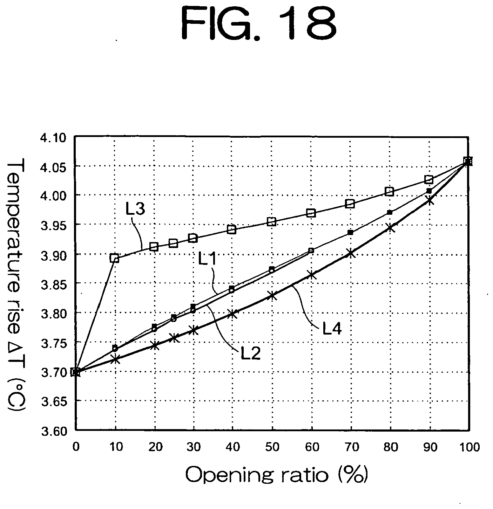

FIG. 18 is a graph showing the analysis results of a temperature rise ΔT (°C) at the center portion of the semiconductor device 30 with respect to the opening ratio (%) of four opening patterns. In this graph, a solid square and L1 indicate the results of a semiconductor-embedded substrate equipped with a heat radiation member 21 having a rectangular opening pattern; a blank circle and line L2 indicate the results of a semiconductor-embedded substrate equipped with a heat radiation member 22 having a circular opening pattern; a blank square and line L3 indicate the results of a semiconductor-embedded substrate equipped with a heat radiation member 23 having a concentric opening pattern; and asterisk and line L4 indicate the results of a semiconductor-embedded substrate equipped with a heat radiation member 24 having a radial opening pattern.

From these results, it has been found that the semiconductor-embedded substrates having the heat radiation members 21 and 22 with a rectangular opening pattern and a circular opening pattern, respectively, tend to suffer from a substantially linear temperature rise with an increase in the opening ratio and temperature rise extents of them are substantially equal when their opening ratios are equal. It has been confirmed that the semiconductor-embedded substrate having the heat radiation member 23 with a concentric opening pattern showed a greater temperature rise than the heat radiation members 21 and 22 having rectangular opening pattern and circular opening pattern, respectively, though the their opening ratios are the same. It has also been confirmed that the semiconductor-embedded substrate having the heat radiation member 24 with a radial opening pattern showed a smaller temperature increase than the heat radiation members 21 and 22 having rectangular opening pattern and circular opening pattern, respectively, though the their opening ratios are the same. These findings have revealed that the radial opening pattern, among four opening patterns, can suppress the temperature increase most efficiently.

As described above, a semiconductor-embedded, substrate equipped with a first heat radiation member such as heat radiation member 23 having a concentric opening pattern is relatively excellent in harmonic-radiation-noise blocking properties. Based on the above-described analysis results and the relationship between the harmonic-radiation-noise blocking properties and opening pattern, a semiconductor-embedded substrate equipped with a first heat radiation member having an opening portion in which a combination of a radial opening pattern and a concentric opening pattern has been formed can have both improved heat radiation properties and harmonic-radiation-noise blocking properties.

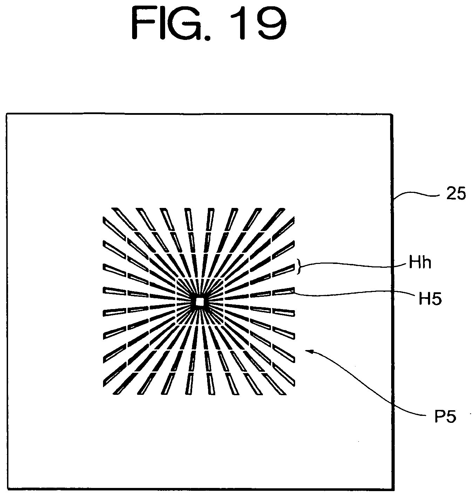

FIG. 19 is a plan view illustrating one embodiment of a first heat radiation member having such an opening portion in which a combination of a radial opening pattern and a concentric opening pattern has been formed. In the heat radiation member 25, a radial opening unit Hh is formed by linear and radial arrangement of a plurality of openings H5 at certain gaps. As illustrated, when plural radial openings Hh are arranged, a pattern in which sites between the openings H5 are concentrically and radially arranged is defined. This pattern is a so-called "web-like" mesh pattern. In it, concentric patterns are defined as a whole and at the same time, heat transfer paths extend from the center portion of the heat radiation member 25 to the circumference thereof without interruption. Such a heat radiation member can therefore has enhanced heat radiation properties and enhanced harmonic-radiation-noise blocking properties simultaneously. The action mechanism is however not limited thereto.

As described above, the present invention is not limited to or by the above-described embodiments and they can be modified without changing the scope of the present invention. For example, in the semiconductor-embedded substrates 100, 200, 300, 400 and 500, the semiconductor device cannot only be used with the face down as illustrated in FIGS. 1 to 4 and FIG. 10, but also be used with the face up. It may be used while inclining it at a predetermined angle. The number of the resin layers of the semiconductor-embedded substrate is not limited to three or five and it may be any number insofar as it is more than one. Moreover, as the opening pattern of the first heat radiation portion, any combination of the patterns shown in the heat radiation members 21 to 24 is usable as needed. It may have, as a concentric opening pattern, openings in the form of an endless circular loop arranged concentrically or openings in the form of a finite spiral loop. The planar shape of the first heat radiation member is not limited to rectangular and any shape can be adopted. The first and second heat radiation members are not limited to those in the form of a flat plate but may be in the form having a bending portion such as curved plate or corrugated shape.

In addition, the first heat radiation member connected directly to the semiconductor device or connected indirectly to the semiconductor device via a member having a greater heat transfer coefficient or thermal conductivity than that of the insulating layer is also preferred. This makes it possible to heighten a heat transfer amount from the semiconductor device to the first heat radiation member, thereby improving the heat radiation properties of the semiconductor-embedded substrate. Moreover, for example in the semiconductor-embedded substrate 100, a plate-like heat radiation member having the opening portion H as the heat radiation member 20 may be placed at a position opposite to the main surface 30a of the semiconductor device 30, for example, between the connection plugs 12 and 12 in the resin layer 1 or between the internal wirings 13 and 13. In this case, the heat radiation member 20 is not necessary but disposal of it is preferred. The heat radiation members 20 to 25, 40 and 41 may not be in the form of a flat plate and it may, for example, be in the form to cover the side wall side of the semiconductor device 30. The semiconductor-embedded substrate 400 does not always need the heat radiation member 41.

As described above, according to the semiconductor-embedded substrate of the present invention and a fabrication process thereof, a first heat radiation member having an opening in which at least one opening has been formed is placed opposite to the semiconductor device so that the substrate can exhibit sufficient heat radiation properties by relaxing a thermal stress during fabrication or use and therefore has improved reliability of the product. The semiconductor-embedded substrate of the present invention can therefore be effectively and widely applied to apparatuses, equipment, systems and devices having a semiconductor device integrated therein, particularly those required to realize downsizing and performance improvement.

## Claims

1. A semiconductor-embedded substrate (100) comprising an insulator (1, 2, 3) and a semiconductor device placed therein, wherein the substrate further comprises:
a first heat radiation member (20) having an opening portion (P) in which a plurality of openings (H) has been formed at a site opposite to the semiconductor device; and having a greater heat transfer coefficient or thermal conductivity than that of the insulating layer (1, 2, 3),
wherein the semiconductor device (30) is in the form of a plate and has a bump (32) formed on one (30a) of the surfaces thereof,
and wherein the first heat radiation member (20) is placed opposite to the other surface (30b) of the semiconductor device (30) and has the opening portion (P) within a region opposite to the other surface (30b) of the semiconductor device (30),
**characterized in that**
in the opening portion (P4) of the first heat radiation member (24), a plurality of the openings (H4) are arranged radially.

2. The semiconductor-embedded substrate according to Claim 1, further comprising a second heat radiation member (40) placed opposite to the opening portion (P) of the first heat radiation member (20) on the side opposite to the semiconductor device (30) with the first heat radiation member between the second heat radiation member and the semiconductor device and having a greater heat transfer coefficient or thermal conductivity than that of the insulating layer (1, 2, 3).

3. The semiconductor-embedded substrate according to Claim 2, wherein the second heat radiation member (40) is not opened at at least a site opposite to the opening portion (P) of the first heat radiation member (20).

4. The semiconductor-embedded substrate according to Claim 2, further comprising a connection portion (35) connected to the first heat radiation member (20) and the second heat radiation member (40) and having a greater heat transfer coefficient or thermal conductivity than that of the insulating layer (1, 2, 3).

5. The semiconductor-embedded substrate according to Claim 1, wherein in the opening portion (P) of the first heat radiation member (20), a plurality of the openings (H) are placed at certain gaps.

6. The semiconductor-embedded substrate according to Claim 1, wherein the first heat radiation member (20) is connected directly to the semiconductor device (30) or connected indirectly to the semiconductor device (30) via a member having a greater heat transfer coefficient or thermal conductivity than that of the insulating layer (1, 2, 3).

7. The semiconductor-embedded substrate according to Claim 1, wherein in the opening (P4) of the first heat radiation member (24), a plurality of wedge-shaped openings (H4) are arranged radially around the center portion of the first heat radiation member (24), which is coaxial with the center portion of the semiconductor device (30).

## Patentansprüche

1. Halbleitereingebettetes Substrat (100) mit einem Isolator (1, 2 3) und einem Halbleiterbauelement, das darin angeordnet ist, wobei das Substrat ferner aufweist:
ein erstes Wärmestrahlungselement (20) mit einem Öffnungsbereich (P), in welchem mehrere Öffnungen (H) an einer Stelle gegenüberliegend zu dem Halbleiterbauelement ausgebildet sind; und das einen größeren Wärmeübertragungskoeffizienten oder eine höhere Wärmeleitfähigkeit hat als der Isolator (1, 2, 3),
wobei das Halbleiterbauelement (30) in Form einer Platte vorliegt und einen Höcker (32) aufweist, der auf einer (30a) ihrer Oberflächen ausgebildet ist,
und wobei das erste Wärmestrahlungselement (20) gegenüberliegend zu der anderen Oberfläche (30b) des Halbleiterbauelements (30) angeordnet ist und den Öffnungsbereich (P) in einem Gebiet hat, das gegenüberliegend zu der anderen Oberfläche (30b) des Halbleiterbauelements (30) liegt,
**dadurch gekennzeichnet, dass**
in dem Öffnungsbereich (P4) des ersten Wärmestrahlungselements (24) mehrere der Öffnungen (H4) radial angeordnet sind.

2. Halbleitereingebettetes Substrat nach Anspruch 1, das ferner ein zweites Wärmestrahlungselement (40) aufweist, das gegenüberliegend zu dem Öffnungsbereich (P) des ersten Wärmestrahlungselements (20) auf der Seite angeordnet ist, die dem Halbleiterbauelement (30) gegenüberliegt, wobei das erste Wärmestrahlungselement zwischen dem zweiten Wärmestrahlungselement und dem Halbleiterbauelement angeordnet ist und einen größeren Wärmeübertragungskoeffizienten oder eine höhere Wärmeleitfähigkeit hat als der Isolator (1, 2, 3).

3. Halbleitereingebettetes Substrat nach Anspruch 2, wobei das zweite Wärmestrahlungselement (40) zumindest an einer Stelle, die dem Öffnungsbereich (P) des ersten Wärmestrahlungselements (20) gegenüberliegt, nicht geöffnet ist.

4. Halbleitereingebettetes Substrat nach Anspruch 2, das ferner einen Verbindungsbereich (35) aufweist, der mit dem ersten Wärmestrahlungselement (20) und dem zweiten Wärmestrahlungselement (40) verbunden ist und einen größeren Wärmeübertragungskoeffizienten oder eine höhere Wärmeleitfähigkeit hat als der Isolator (1, 2, 3).

5. Halbleitereingebettetes Substrat nach Anspruch 1, wobei in dem Öffnungsbereich (P) des ersten Wärmestrahlungselements (20) mehrere der Öffnungen (H) an gewissen Lücken angeordnet sind.

6. Halbleitereingebettetes Substrat nach Anspruch 1, wobei das erste Wärmestrahlungselement (20) direkt mit dem Halbleiterbauelement (30) oder indirekt mit dem Halbleiterbauelement (30) über ein Element verbunden ist, das einen größeren Wärmeübertragungskoeffizienten oder eine höhere Wärmeleitfähigkeit hat als der Isolator (1, 2, 3).

7. Halbleitereingebettetes Substrat nach Anspruch 1, wobei in dem Öffnungsbereich (P4) des ersten Wärmestrahlungselements (24) mehrere keilförmige Öffnungen (H4) radial um den zentralen Bereich des ersten Wärmestrahlungselements (24), der koaxial zu dem zentralen Bereich des Halbleiterbauelements (30) ist, herum angeordnet sind.

## Revendications

1. Substrat à semi-conducteur incorporé (100) comprenant un isolant (1, 2, 3) et un dispositif à semi-conducteur placé dans celui-ci, dans lequel le substrat comprend en outre :
un premier élément de rayonnement de chaleur (20) ayant une partie d'ouverture (P) dans laquelle une pluralité d'ouvertures (H) a été formée au niveau d'un site opposé au dispositif à semi-conducteur ; et ayant un coefficient de transfert de chaleur ou une conductivité thermique supérieur à celui de la couche isolante (1, 2, 3),
dans lequel le dispositif à semi-conducteur (30) se présente sous la forme d'une plaque et comporte une bosse (32) formée sur l'une (30a) de ses surfaces,
et dans lequel le premier élément de rayonnement de chaleur (20) est placé à l'opposé de l'autre surface (30b) du dispositif à semi-conducteur (30) et a la partie d'ouverture (P) dans une région opposée à l'autre surface (30b) du dispositif à semi-conducteur (30),
**caractérisé en ce que**
dans la partie ouverture (P4) du premier élément de rayonnement de chaleur (24), une pluralité des ouvertures (H4) sont agencées radialement.

2. Substrat à semi-conducteur incorporé selon la revendication 1, comprenant en outre un second élément de rayonnement de chaleur (40) placé à l'opposé de la partie d'ouverture (P) du premier élément de rayonnement de chaleur (20) sur le côté opposé au dispositif à semi-conducteur (30) avec le premier élément de rayonnement de chaleur situé entre le second élément de rayonnement de chaleur et le dispositif à semi-conducteur et ayant un coefficient de transfert de chaleur ou une conductivité thermique qui est supérieur à celui de la couche isolante (1, 2, 3).

3. Substrat à semi-conducteur incorporé selon la revendication 2, dans lequel le second élément de rayonnement de chaleur (40) n'est pas ouvert au niveau d'au moins un site opposé à la partie d'ouverture (P) du premier élément de rayonnement de chaleur (20).

4. Substrat à semi-conducteur incorporé selon la revendication 2, comprenant en outre une partie de connexion (35) connectée au premier élément de rayonnement de chaleur (20) et au second élément de rayonnement de chaleur (40) et ayant un coefficient de transfert de chaleur ou une conductivité thermique supérieur à celui de la couche isolante (1, 2, 3).

5. Substrat à semi-conducteur incorporé selon la revendication 1, dans lequel, dans la partie d'ouverture (P) du premier élément de rayonnement de chaleur (20), une pluralité des ouvertures (H) sont placées à certains intervalles.

6. Substrat à semi-conducteur incorporé selon la revendication 1, dans lequel le premier élément de rayonnement de chaleur (20) est connecté directement au dispositif à semi-conducteur (30) ou connecté indirectement au dispositif à semi-conducteur (30) via un élément ayant un coefficient de transfert de chaleur ou une conductivité thermique supérieur à celui de la couche isolante (1, 2, 3).

7. Substrat à semi-conducteur incorporé selon la revendication 1, dans lequel, dans l'ouverture (P4) du premier élément de rayonnement de chaleur (24), une pluralité d'ouvertures en forme de coin (H4) sont agencées radialement autour de la partie centrale du premier élément de rayonnement de chaleur (24), qui est coaxiale avec la partie centrale du dispositif à semi-conducteur (30).
